# EUROPEAN PATENT APPLICATION

(11) **EP 1 400 850 A1**
(43) Date of publication of application: **24.03.2004**
(21) Application number: 02733301.2
(22) Date of filing: 05.06.2002
(51) Int. Cl.: G03F 7/022, G03F 7/033, G03F 7/004

(54) **METHOD OF FORMING THICK RESIST PATTERN**

(30) Priority: 12.06.2001 JP 2001177561
(71) Applicant: CLARIANT INTERNATIONAL LTD., 4132 Muttenz (CH)
(72) Inventor: TAKAHASHI, Shuichi, c/o Clariant (Japan) K.K., Ogasa-gun, Shizuoka 437-1496 (JP)
(74) Representative: Hütter, Klaus, Dr.
(86) International application number: PCT/JP2002/005523
(87) International publication number: WO 2002/101467

(57) **Abstract**

A radiation sensitive resin composition for forming a thick film resist pattern comprises an alkali-soluble resin and a photosensitizer containing a quinone diazide group, wherein the alkali-soluble resin is a mixture of a novolak resin and one or more resins selected from the group consisting of (i) a polyacrylate, (ii) a polymethacrylate, (iii) a polystyrene derivative, and (iv) a copolymer comprising two or more monomer units selected from the group of an acrylate, a methacrylate and a styrene derivative. The composition is applied on a substrate to form a 2.0 µm or more of resist film in thickness. The resist film is exposed to light and developed to form a thick film resist pattern. The radiation sensitive resin composition may contain a low-molecular or high-molecular compound having phenolic hydroxyl group or groups as a dissolution promoter or a sensitivity improving agent, a fluorescent material as a sensitizer, etc.

## Description

### Technical Field

The present invention relates to a pattern forming method for resist with thick film thickness used for a manufacturing of a semiconductor device, a magnetic head, a micro machine, etc. favorably and a radiation sensitive resin composition used therefor, more in details, the present invention relates to a pattern forming method for resist with thick film thickness which can maintain higher sensitivity than a radiation sensitive resin composition so far being used and is suitable for corrosion-prevention of a substrate as the development time can be shortened upon forming a thick film resist pattern using photoresist having the film thickness of 2.0 µm or more and to a radiation sensitive resin composition used therefor.

### Background Art

In the wide field such as manufacturing semiconductor integrated circuits such as LSI, manufacturing a circuit substrate for thermal head etc., and like use, photolithography technique has so far been employed for forming microelements or conducting fine processing. In the photolithography technique, a positive or negative-working radiation sensitive resin composition is used for forming a resist pattern. Of these radiation sensitive resin compositions, those compositions comprising an alkali-soluble resin and a radiation sensitive material of quinone diazide compound are popularly used as the positive-working radiation sensitive resin compositions. As such compositions, there are described compositions having different formulations as, for example, 'novolak resin/quinone diazide compound' in many documents such as Japanese Examined Patent Publication No. Sho 54-23570 (US Patent No. 3,666,473), Japanese Examined Patent Publication No. Sho 56-30850 (US Patent No. 4,115,128), Japanese Unexamined Patent Publication Nos. Sho 55-73045 and Sho 61-205933, etc.

These compositions comprising a novolak resin and a quinone diazide compound have so far been studied and developed with respect to both novolak resins and radiation sensitive materials. In respect of novolak resins, there have been developed novel resins. In addition, radiation sensitive resin compositions having excellent properties have also been obtained by improving physical properties of conventionally known resins. For example, there are disclosed techniques providing a radiation sensitive resin composition having excellent properties by using a novolak resin with a particular molecular weight distribution in Japanese Unexamined Patent Publication Nos. Sho 60-140235 and Hei 01-105243 and by using a novolak resin from which low-molecular-weight components of the resin has been removed by fractionation in Japanese Unexamined Patent Publication Nos. Sho 60-97347 and Sho 60-189739 and Japanese Patent Publication No.2590342.

On the other hand, regarding a resist with thick film thickness used for a manufacturing of semiconductor device, magnetic head, micro machine, etc. favorably, one having high sensitivity and high resolution is required more and more and it is becoming more necessary to form the resist pattern having higher aspect ratio. In order to maintain high sensitivity, it is being believed to make transmittance of photoresist high so far and therefore the way to reduce the amount of photosensitizing agent in a radiation sensitive resin composition is being taken as one method. However this method has a problem that film remaining ratio is lowered, particularly it is problematic as a pattern forming method for resist with thick film thickness.

Under the circumstances described above, an object of the present invention is to provide a pattern forming method for resist with thick film thickness without causing deterioration of a sensitivity and a film remaining ratio but to form a good pattern having high resolution but without tailing etc. and a radiation sensitive resin composition for forming a thick film resist pattern using therefor.

### Disclosure of the Invention

As a result of eager study and examination, the present inventor found that the above object can be attained by use of a radiation sensitive resin composition comprising an alkali-soluble resin and a quinone diazide group-containing photosensitizer wherein the alkali-soluble resin is a mixture of a novolak resin and one or more resins selected from the group consisting of (i) a polyacrylic ester, (ii) a polymethacrylic ester, (iii) a polystyrene derivative, and (iv) a copolymer comprising two or more monomer units selected from the group of an acrylic ester, a methacrylic ester and a styrene derivative upon forming a thick film resist pattern using photoresist having a film thickness of 2.0 µm or more and the present inventor reached to the present invention.

It means the present invention relates to a method of forming a thick film resist pattern which is characterized in that in a method of forming a thick film resist pattern using photoresist film having the film thickness of 2.0 µm or more, a radiation sensitive resin composition comprises an alkali-soluble resin and a photosensitizer containing a quinone diazide group, wherein said alkali-soluble resin is a mixture of a novolak resin and one or more resins selected from the group consisting of (i) a polyacrylic ester, (ii) a polymethacrylic ester, (iii) a polystyrene derivative, and (iv) a copolymer comprising two or more monomer units selected from the group of an acrylic ester, a methacrylic ester and a styrene derivative.

Furthermore the present invention relates to a radiation sensitive resin composition for forming a thick film resist pattern which is characterized in that in a radiation sensitive resin composition comprising an alkali-soluble resin and a photosensitizer containing a quinone diazide group, said alkali-soluble resin is a mixture of a novolak resin and one or more resins selected form the group consisting of (i) a polyacrylic ester, (ii) a polymethacrylic ester, (iii) a polystyrene derivative, and (iv) a copolymer comprising two or more monomer units selected from the group of an acrylic ester, a methacrylic ester and a styrene derivative.

### Detailed Description of the Invention

Hereinafter, the present invention will be described below further in more detail.

In the pattern forming method for resist with thick film thickness of the present invention, the thickness of a photoresist film is 2.0 µm or more and as a radiation sensitive resin composition an alkali-soluble resin and a quinone diazide group-containing photosensitizer is used, wherein said alkali-soluble resin is a mixture of a novolak resin and one or more resins selected from the group consisting of (i) a polyacrylic ester, (ii) a polymethacrylic ester, (iii) a polystyrene derivative, and (iv) a copolymer comprising two or more monomer units selected from the group of an acrylic ester, a methacrylic ester and a styrene derivative.

A novolak resin preferably used in a radiation sensitive resin composition for forming a thick film resist pattern of the present invention may be the novolak resin used in the radiation sensitive resin composition so far known containing alkaline-soluble resin and photosensitizer containing a quinone diazide group and is not limited particularly. A novolak resin preferably used in the present invention is obtained by polycondensation between a various kind of phenol species, singly or a mixture thereof and aldehydes such as formalin.

As the phenols to be used for preparing the novolak resin, there may be illustrated, for example, phenol, p-cresol, m-cresol, o-cresol, 2,3-dimethylphenol, 2,4-dimethylphenol, 2,5-dimethylphenol, 2,6-dimethylphenol, 3,4-dimethylphenol, 3,5-dimethylphenol, 2,3,4-trimethylphenol, 2,3,5-trimethylphenol, 3,4,5-trimethylphenol, 2,4,5-trimethylphenol, methylene-bisphenol, methylene-bis-p-cresol, resorcinol, catechol, 2-methylresorcinol, 4-methylresorcinol, o-chlorophenol, m-chlorophenol, p-chlorophenol, 2,3-dichlorophenol; m-methoxyphenol, p-methoxyphenol, o-methoxyphenol, p-butoxyphenol, o-ethylphenol, m-ethylphenol, p-ethylphenol, 2,3-diethylphenol, 2,5-diethylphenol, p-isopropylphenol, α-naphthol, β-naphthol, and the like. These are used singly or in a mixture of two or more kinds thereof.

As the aldehydes, there may be illustrated paraformaldehyde, acetaldehyde, benzaldehyde, hydroxybenzaldehyde, chloroacetaldehyde, etc. as well as formalin. These are used singly or in a mixture of two or more kinds thereof.

The weight average molecular weight of the novolak resin used in the radiation sensitive resin composition of the present invention, as determined by polystyrene standards, is preferably 2,000 to 50,000, more preferably 3,000 to 40,000.

On the other hand, as monomers constituting a polyacrylic ester (i), a polymethacrylic ester (ii), a polystyrene derivative (iii), and a copolymer comprising two or more monomer units selected from the group of an acrylic ester, a methacrylic ester and a styrene derivative (iv) , which are used with novolak resin in the radiation sensitive resin composition for forming a thick film resist pattern of the present invention, below described acrylic ester, methacrylic ester and styrene derivatives are preferably raised.

### Acrylic ester:

Methyl acrylate, ethyl acrylate, n-propyl acrylate, n-butyl acrylate, n-hexyl acrylate, isopropyl acrylate, isobutyl acrylate, t-butyl acrylate, cyclohexyl acrylate, benzyl acrylate, 2-chloroethyl acrylate, methyl-α-chloroacrylate, phenyl α-bromoacrylate, etc.

### Methacrylic ester:

Methyl methacrylate, ethyl methacrylate, n-propyl methacrylate, n-butyl methacrylate, n-hexyl methacrylate, isopropyl methacrylate, isobutyl methacrylate, t-butyl methacrylate, cyclohexyl methacrylate, benzyl methacrylate, phenyl methacrylate, 1-phenylethyl methacrylate, 2-phenylethyl methacrylate, furfuryl methacrylate, diphenylmethyl methacrylate, pentachlorophenyl methacrylate, naphthyl methacrylate, iso-boronyl methacrylate, benzyl methacrylate, etc.

### Styrene derivatives:

4-fluorostyrene, 2,5-difluorostyrene, 2,4-difluorostyrene, p-isopropylstyrene, styrene, o-chlorostyrene, 4-acetylstyrene, 4-bezoylstyrene, 4-bromostyrene, 4-butoxycarbonylstyrene, 4-butoxymethylstyrene, 4-butylstyrene, 4-ethylstyrene, 4-hexylstyrene, 4-methoxystyrene, 4-methylstyrene, 2,4-dimethylstyrene, 2,5-dimethylstyrene, 2,4,5-trimethylstyrene, 4-phenylstyrene, 4-propoxystyrene, etc.

Further an organic acid monomer can be used as a copolymer component for the above described each polymer or copolymer. The preferable organic acid monomer can be illustrated below.

### Organic acid monomer:

Acrylic acid, methacrylic acid, itaconic acid, maleic anhydride, 2-acryloyl hydrogenphthalate, 2-acryloyl oxypropyl hydrogenphthalate, etc.

When using an organic acid monomer as a copolymer component, acrylic ester, methacrylic ester and styrene derivatives in the copolymers show alkaline dissolution inhibition effect, whereas an organic acid monomer part shows alkaline dissolution improvement effect. Therefore depending on the content of an organic acid monomer it would be possible to balance dissolution inhibition effect and dissolution improvement in the light exposure area of the radiation sensitive resin composition to a developer suitably.

Besides the weight average molecular weight of a polyacrylic ester, a polymethacrylic ester, a polystyrene derivative and a copolymer comprising two or more of monomer unit selected from the group consisting of an acrylic ester, a methacrylic ester and a styrene derivative is preferably 2,000 to 80,000 as determined by polystyrene standards and is more preferably 5,000 to 40,000. The content of a polyacrylic ester, a polymethacrylic ester, a polystyrene derivative and a copolymer comprising two or more of monomer units selected from the group consisting of an acrylic ester, a methacrylic ester, a styrene derivative is preferably 0.1 to 10.0 parts by weight relative to 100 parts by weight of novolak resin and is more preferably 0.5 to 5.0 parts by weight.

As a photosensitizer containing a quinone diazide group which is used in the radiation sensitive resin composition for forming the thick film resist pattern of the present invention, any publicly known photosensitizer containing a quinone diazide group can be used and particularly one obtained by the reaction between quinone diazide sulfonic acid halide such as naphthoquinone diazide sulfonic acid chloride or benzoquinone diazide sulfonic acid chloride and low or high molecular weight compounds containing functional groups which can be condensed with these acid halide is preferred. As functional groups that can be condensed with these acid halides, a hydroxyl group or an amino group can be exemplified and particularly a hydroxyl group is suitable. As the low molecular compounds containing hydroxyl groups, for example, hydroquinone, resorcinol, 2,4-dihydroxybenzophenone, 2,3,4-trihydroxybenzophenone, 2,4,6-trihydroxybenzophenone, 2,4,4'-trihydroxybenzophenone, 2,3,4,4'-tetrahydroxybenzophenone, 2,2',4,4'-tetrahydroxybenzophenone, 2,2',3,4,6'-pentahydroxybenzophenone, etc. are exemplified. Examples of the high molecular compounds containing hydroxyl groups include novolak resin, polyhydroxystyrene, etc.

Either a single compound or a mixture of two or more photosensitizers may be used as a photosensitizer containing a quinone diazide group in the present invention. In the above exemplified photosensitizers the esterified compound between tetrahydroxy benzophenone and 1,2-naphthoquinone diazide sulphonic acid is raised preferably and the mixture of esterified compounds between tetrahydroxy benzophenone and 1,2-naphthoquinone diazide sulphonic acid having two or more of different average esterification rates are particularly preferred.

In the present invention the content of a photosensitizer containing a quinone diazide group is preferred to be 10 to 30 parts by weight, more preferably 15 to 25 parts by weight relative to 100 parts by weight of resin component of the radiation sensitive resin composition. In the case of less than 10 parts by weight the film remaining ratio tends to decrease or the process margin such as development time dependency tends to be deteriorated drastically. In the case of more than 30 parts by weight, it could cause a practical problem due to too low sensitivity and causing the precipitation of a photosensitizer.

In the present invention, it is further preferred to incorporate the low molecular compounds having the phenolic hydroxyl group or groups represented by the general formula (I) below into the radiation sensitive resin composition. 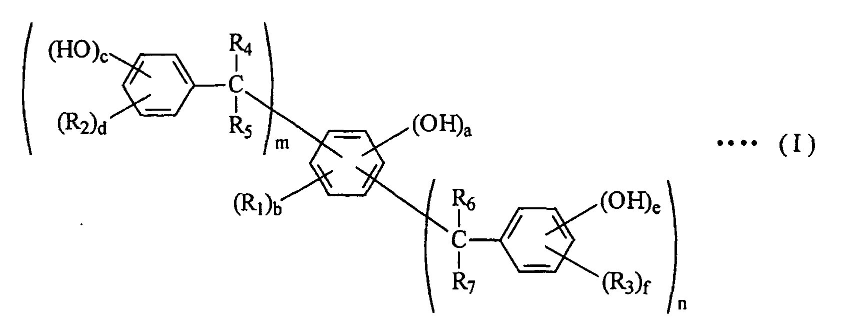 Wherein R₁, R₂, R₃, R₄, R₅, R₆ and R₇ independently represent H, a C₁-C₄ alkyl group, a C₁-C₄ alkoxyl group, a cyclohexyl group, or a group represented by the formula: 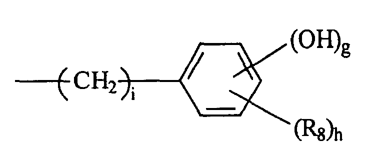 wherein R₈ represents H, a C₁-C₄ alkyl group, a C₁-C₄ alkoxyl group or a cyclohexyl group; m and n each are 0, 1 or 2; a, b, c, d, e, f, g and h are integers of 0 or 1 to 5 satisfying a + b ≦ 5, c + d ≦ 5, e + f ≦ 5, and g + h ≦ 5; and i is 0, 1 or 2.

In the radiation sensitive resin composition of the present invention, the low molecular compounds having the phenolic hydroxyl group or groups represented by the general formula (I) are preferably used to control a dissolution rate usually as a dissolution promoter or to improve or control the sensitivity of the radiation sensitive resin composition.

As the low-molecular compound having phenolic hydroxyl group or groups represented by the above general formula (I), there are illustrated, for example, o-cresol, m-cresol, p-cresol, 2,4-xylenol, 2,5-xylenol, 2,6-xylenol, bisphenol A, B, C, E, F, or G, 4,4',4"-methylidinetrisphenol, 2,6-bis[(2-hydroxy-5-methylphenyl)methyl]-4-methylphenol, 4,4'-[1-[4-[1-(4-hydroxyphenyl)-1-methylethyl]phenyl]ethylidene]bisphenol, 4,4',4"-ethylidinetrisphenol, 4-[bis(4-hydroxyphenyl)methyl]-2-ethoxyphenol, 4,4'-[(2-hydroxyphenyl)methylene]bis[2,3-dimethylphenol], 4,4'-[(3-hydroxyphenyl)methylene]bis[2,6-dimethylphenol], 4,4'-[(4-hydroxyphenyl)methylene]bis[2,6-dimethylphenol], 2,2'-[(2-hydroxyphenyl)methylene]bis[3,5-dimethylphenol], 2,2'-[(4-hydroxyphenyl)methylene]bis[3,5-dimethylphenol], 4,4'-[(3,4-dihydroxyphenyl)methylene]bis[2,3,6-trimethylphenol], 4-[bis(3-cyclohexyl-4-hydroxy-6-methylphenyl)methyl]-1,2-benzenediol, 4,6-bis[(3,5-dimethyl-4-hydroxyphenyl)methyl]-1,2,3-benzenetriol, 4,4'-[(2-hydroxyphenyl)methylene]bis[3-methylphenol], 4,4',4"-(3-methyl-1-propanyl-3-ylidine)trisphenol, 4,4',4",4'''-(1,4-phenylenedimethylidine)tetrakisphenol, 2,4,6-tris[(3,5-dimethyl-4-hydroxyphenyl)methyl]-1,3-benzenediol, 2,4,6-tris[(3,5-dimethyl-2-hydroxyphenyl)methyl]-1,3-benzenediol, 4,4'-[1-[4-[1-[4-hydroxy-3,5-bis[(hydroxy-3-methylphenyl]methyl]phenyl]-1-methylethyl]phenyl]ethylidene]bis[2,6-bis(hydroxy-3-methylphenyl)methyl]phenol, and the like. These low-molecular compounds having phenolic hydroxyl group or groups are used in an amount of usually 1 to 20 parts by weight relative to 100 parts by weight of a novolak resin, preferably 3 to 15 parts by weight.

In addition a fluorescent material can be added into the radiation sensitive resin composition of the present invention. The fluorescent material which is used in the radiation sensitive resin composition of the present invention include naphthalene and naphthalene derivatives, e.g., 1-hydroxynaphthalene, 1-methylnaphthalene, 2,3-dimethylnaphthalene, 1-aminonaphthalene, 2-fluoronaphthalene, 2-chloronaphthalene, 1,7-diphenylnaphthalene, and the like; anthracene and anthracene derivatives, e.g., 9-methylanthracene, 9,10-dimethylanthracene, 9-cyanoanthracene, 1-aminoanthracene, 9-phenylanthracene, 9,10-diphenylanthracene, 9,10-dichloroanthracene, 9,10-dinaphthylanthracene, 9-vinylanthracene, 9-(p-vinylphenyl)-10-phenylanthracene, and the like; phenanthrene and phenanthrene derivatives, e.g., 3,4'-benzophenanthrene, 2-phenylphenanthrene, and the like; pyrene and pyrene derivatives, e.g., 1,3,6,8-tetraphenylpyrene, bipyrenyl, o-phenylenepyrene, and the like; perylene and perylene derivatives, e.g., benzoperylene and the like; fluorene and fluorene derivatives, e.g., 1-methylfluorene, 1,2-benzofluorene, and the like; carbazole and carbazole derivatives, e.g., N-methylcarbazole, N-methylbenzocarbazole, N-phenylcarbazole, N-vinylcarbazole, and the like; biphenyl and biphenyl derivatives, e.g., 4-methylphenylbiphenyl, 3,3'-dimethylbiphenyl, 4-methoxybiphenyl, 4,4'-dimethoxybiphenyl, 4,4'-dihydroxybiphenyl, 4-benzylbiphenyl, 4-vinylbiphenyl, octamethylbiphenyl and the like; p-terphenyl and p-terphenyl derivatives, e.g., 4-methylterphenyl, 2-methyl-p-terphenyl, 3,3"-dimethylterphenyl, 4-(3,3-dimethylbutoxy)-p-terphenyl, 2,2'-methylene-p-terphenyl, and the like; p-quaterphenyl and p-quaterphenyl derivatives, e.g., 3,3'''-dimethyl-p-quaterphenyl, tetramethyl-p-quaterphenyl, 4-(3-ethylbutoxy)-p-quaterphenyl, and the like; indole and indole derivatives, e.g., 2-phenylindole, 1-methyl-2-phenylindole, 1-N-butyl-2-biphenylindole, 1,2-diphenylindole, 1-biphenyl-2-indole, and the like; acridine and derivatives thereof; naphthacene and derivatives thereof; rublene and derivatives thereof; chrysene and derivatives thereof; and so on. It is preferred that these fluorescent materials are selected by taking into account the absorption wavelength range of the photosensitizer to be combined and then these fluorescent materials may be used singly or in a mixture of two or more kinds thereof. The amount of the fluorescent material to be incorporated is 0.0001 to 1.0 parts by weight, preferably 0.0005 to 0.5 parts by weight relative to 100 parts by weight of the photosensitive material. The incorporation of these fluorescent materials can improve the sensitivity of the radiation sensitive resin composition.

The solvents for dissolving an alkali-soluble resin, a photosensitizer and the dissolution promoter represented by the general formula (I) of the present invention include ethylene glycol monoalkyl ethers such as ethylene glycol monomethyl ether and ethylene glycol monoethyl ether; ethylene glycol monoalkyl ether acetates such as ethylene glycol monomethyl ether acetate and ethylene glycol monoethyl ether acetate; propylene glycol monoalkyl ethers such as propylene glycol monomethyl ether and propylene glycol monoethyl ether; propylene glycol monoalkyl ether acetates such as propylene glycol monomethyl ether acetate and propylene glycol monoethyl ether acetate; lactates such as methyl lactate and ethyl lactate; aromatic hydrocarbons such as toluene and xylene; ketones such as methyl ethyl ketone, 2-heptanone, and cyclohexanone; amides such as N,N-dimethylacetamide and N-methylpyrrolidone; lactones such as γ -butyrolactone and so on. These solvents are used singly or in a mixture of two or more kinds thereof. The radiation sensitive resin composition is applied, for example, on a substrate as a solution wherein the constituent components are dissolved in the solvent.

Further, dyestuffs, adhesive aids, surfactants, etc. may be incorporated as necessary into the radiation sensitive resin composition of the present invention. The dyestuffs include e.g. Methyl Violet, Crystal Violet, Malachite Green, etc.; the adhesive aids include e.g. alkyl imidazoline, butyric acid, alkyl acid, polyhydroxystyrene, polyvinylmethyl ether, t-butyl novolak, epoxy silane, epoxy polymer, silane, etc.; and the surfactants include e.g. nonionic surfactants such as polyglycols and derivatives thereof, that is, polypropylene glycol or polyoxyethylene lauryl ether, fluorine-containing surfactants such as Fluorad (trade name; manufactured by Sumitomo 3M Ltd.), Megafac (trade name; manufactured by Dainippon Ink & Chemicals, Inc.), Sulflon (trade name; manufactured by Asahi Glass Co., Ltd.) or organosiloxane surface active agents such as KP341 (trade name; Shin-Etsu Chemical Co., Ltd.).

The pattern forming method for resist with thick film thickness of the present invention may be the same as any pattern forming method for thick film resist so far known excluding using a radiation sensitive resin composition comprising an alkali-soluble resin and a quinone diazide group-containing photosensitizer wherein the alkali-soluble resin is a mixture of a novolak resin and one or more resins selected from the group consisting of (i) a polyacrylic ester, (ii) a polymethacrylic ester, (iii) a polystyrene derivative, and (iv) a copolymer comprising two or more monomer units selected from the group of an acrylic ester, a methacrylic ester and a styrene derivative.

It means, first an alkali-soluble resin, a photosensitizer containing a quinone diazide group and other additives which are optionally used are dissolved in a solvent. The solution thereof is optionally filtrated by a filter in order to remove insoluble substances or impurities to obtain a radiation sensitive resin composition. This composition is applied on a substrate etc. by the proper method so far known such as spin coating, roll coating, dip coating, spray coating to form a photoresist film having film thickness of 2.0 µm or more. When forming a photoresist film, the prebake is conducted after applying a radiation sensitive resin composition if necessary. This photoresist film is usually pattern-wise exposed to light through a photo mask, developed and is made a thick film resist pattern. The exposure to light of photoresist film is generally conducted by visible light, ultra-violet light, deep ultra-violet light by using mercury lamp, metal halide lamp, xenon lamp, mercury xenon lamp, KrF excimer laser, ArF excimer laser, KrCl excimer laser, Xe excimer laser, XeCl excimer laser, etc. The exposure light source or wavelength range of light used for exposure is selected in accordance with the radiation sensitive wavelength region of a radiation sensitive resin composition. Exposure can be also conducted if necessary by X ray or electron beam.

After exposure, post exposure bake (PEB) is conducted if necessary. Then development is conducted. Post-bake is conducted after development if necessary and a thick film resist pattern is formed. In this invention, as the developer which is used for a development of photoresist film, any developer can be used which is used for a development of a radiation sensitive resin composition containing an alkali-soluble resin and a photosensitizer containing a quinone diazide group so far being used. As such developer an aqueous solution of organic quaternary ammonium salt such as tetramethylammonium hydroxide (TMAH), organic amine, metal hydroxide such as sodium hydroxide can be exemplified as representative ones. The concentration of alkali developer, development time and development temperature may be chosen within the limit so far known. For example, when the radiation sensitive resin composition containing alkali-soluble novolak resin and 1,2-naphthoquinone diazide sulfonic acid ester is developed with TMAH aqueous solution, developer concentration is usually 1 to 5 weight %, preferably 2 to 3 weight %, development time is usually 5 to 300 seconds, preferably 10 to 120 seconds, and development time is usually 15 to 30°C, preferably 20 to 25°C.

### Brief explanation of Drawing

Figure-1 shows a diagram indicating the relationship of the sensitivity to film thickness in the Examples and the Comparative Example when developed for 10 seconds.
Figure-2 shows a diagram indicating the relationship of the sensitivity to film thickness in the Examples and the Comparative Example when developed for 30 seconds.
Figure-3 shows a diagram indicating the relationship of the sensitivity to film thickness in the Examples and the Comparative Example when developed for 60 seconds.

### Best mode for practicing the Invention

The present invention will now be described more specifically by reference to Examples which, however, are not to be construed to limit the present invention in any way.

### Example 1

100 parts by weight of a novolak resin having weight average molecular weight 8,000 as determined by polystyrene standards, 2 parts by weight of poly(methylmethacrylate-co-n-butylmethacrylate), 21 parts by weight of the mixture of the esterification product between 2,3,4,4'-tetrahydroxybenzophenone and 1,2-naphthoquinone diazide-5-sulfonyl chloride having average esterification rate of 87.5 % and the esterification product between 2,3,4,4'-tetrahydroxybenzophenone and 1,2-naphthoquinone diazide-5-sulfonyl chloride having average esterification rate of 75.0 % (a mixing ratio, 50:50), and 5 parts by weight of 4,4'-[1-[4-[1-(4-hydroxyphenyl)-1-methylethyl]phenyl]ethylidene]bisphenol were dissolved in propylene glycol monomethyl ether acetate. After adding thereto 300 ppm of a fluorine-containing surfactant, Megafac (manufactured by Dainippon Ink & Chemicals, Inc.) to the total solid content, the solution was stirred and filtered through a 0.2-µm filter to prepare a radiation sensitive resin composition of the present invention. This composition was spin-coated on a 4-inch silicon wafer and a 4-inch glass wafer, and baked on a hot plate at 100°C for 90 seconds to obtain resist films having film thickness of 2.0 µm, 2.4 µm, 4.0 µm and 8.0 µm, each. These resist films were each exposed by the stepper manufactured by Nikon Co., Ltd. (FX-604F, g+h mixture, NA=0.1) and developed in a 2.45 weight % aqueous solution of tetramethylammonium hydroxide at 23°C for 10, 30 and 60 seconds, respectively. After that, exposure energy quantity (Eth) was measured as a sensitivity by scanning electron microscope (SEM) when a resist pattern after development is resolved at 1:1 line and space pattern of 5 µm to obtain the results of Table-1. The film remaining ratios of these cases were 95 to 100 % and pattern shapes were all rectangular and good.

### Example 2

The same manner was taken as Example 1 except for adding anthracene that is a fluorescent substance, 2.1X10⁻⁵ parts by weight (0.005 parts by weight to a photosensitizer) and the results of Table-1 were obtained. The film remaining ratios of these cases were 95 to 100 % and pattern shapes were all rectangular and good.

### Comparative Example 1

The same manner was taken as Example 1 except for not using poly(methylmethacrylate-co-n-butylmethacrylate) and putting the photosensitizer dose 25 parts by weight and the results of Table-1 were obtained. The film remaining ratios of these cases were 93 to 100 % and pattern shapes were all rectangular and good.

**Table-1**

| Eth in each condition (unit: mJ/cm²) | | | | |
|---|---|---|---|---|
| | Film thickness (µm) | Development time | | |
| | | 10 sec | 30 sec | 60 sec |
| Example 1 | 2.0 | 154 | 63 | 34 |
| | 2.4 | 214 | 87 | 47 |
| | 4.0 | 485 | 198 | 106 |
| | 8.0 | 1250 | 511 | 275 |
| Example 2 | 2.0 | 142 | 56 | 30 |
| | 2.4 | 198 | 78 | 43 |
| | 4.0 | 435 | 171 | 92 |
| | 8.0 | 1150 | 453 | 243 |
| Comparative Example 1 | 2.0 | 205 | 72 | 38 |
| | 2.4 | 322 | 115 | 64 |
| | 4.0 | 630 | 233 | 142 |
| | 8.0 | 1650 | 611 | 341 |

The results of Table-1 are shown as diagrams of each development times in Fig.-1 to Fig.-3 when putting film thickness in µm as horizontal axis and sensitivity in mJ/cm² as vertical axis.

From Fig.-1 to Fig.-3, the thicker the film thickness of photoresist film becomes, the drastically lower the sensitivity becomes in the case of the radiation sensitive resin composition so far applied. Whereas according to the pattern forming method of resist with thick film thickness using the radiation sensitive resin composition of the present invention, it is proved that the thicker the film thickness becomes, the higher the controlling effectiveness of sensitivity deterioration becomes towards an increase of film thickness, besides the sensitivity is kept higher than the case so far applied not depending on the film thickness of a photoresist film.

### Effect of the Invention

As mentioned above, according to the present invention a thick film resist pattern which is used when manufacturing a semiconductor device, a magnetic head, a micro machine, etc. can be formed in higher sensitivity than the case using the radiation sensitive resin composition so far applied, without causing deterioration of film remaining ratio and with high resolution. The thick film resist pattern obtained by the present invention has no tailing and a good pattern shape.

### Industrial applicability

As mentioned above the radiation sensitive resin composition of the present invention can be applied for a photoresist for forming a resist pattern with thick film thickness and can be properly used for manufacturing semiconductor devices, a magnetic head, a micro machine, etc.

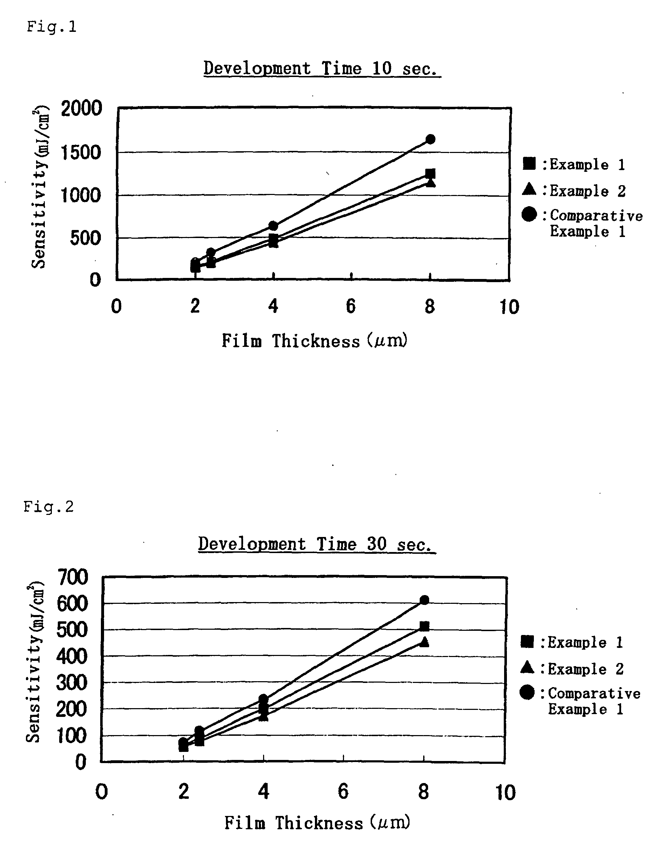

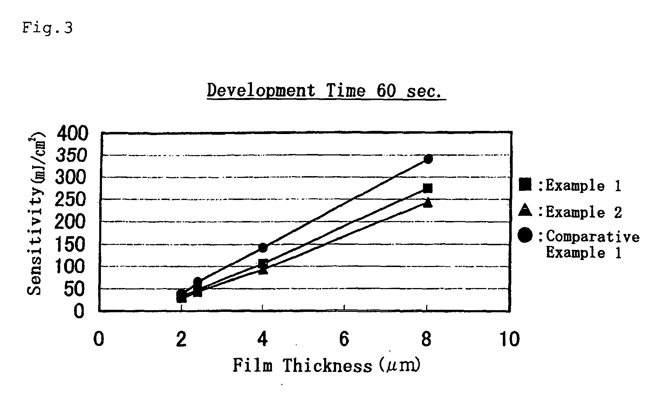

## Claims

1. A method of forming a thick film resist pattern using a photoresist film having a film thickness of 2.0 µm or more, wherein a radiation sensitive resin composition comprises an alkali-soluble resin and a photosensitizer containing a quinone diazide group, and said alkali-soluble resin is a mixture of a novolak resin and one or more resins selected from the group consisting of (i) a polyacrylic ester, (ii) a polymethacrylic ester, (iii) a polystyrene derivative, and (iv) a copolymer comprising two or more monomer units selected from the group of an acrylic ester, a methacrylic ester and a styrene derivative.

2. The method of forming a thick film resist pattern according to claim 1, wherein the photosensitizer containing a quinone diazide group is a mixture of two or more of esterified products having different esterification rate, which are produced by esterifying 1,2-naphthoquinone diazide sulfonic acid with tetrahydroxy benzophenone.

3. The method of forming a thick film resist pattern according to claim 1 or 2, wherein the radiation sensitive resin composition contains a fluorescent material in an amount of 0.0001 to 1.0 part by weight relative to 100 parts by weight of the photosensitizer containing a quinone diazide group.

4. A radiation sensitive resin composition for forming a thick film resist pattern comprising an alkali-soluble resin and a photosensitizer containing a quinone diazide group for use in the method of forming a thick film resist pattern according to claim 1, wherein said alkali-soluble resin is a mixture of a novolak resin and one or more resins selected from the group consisting of (i) a polyacrylic ester, (ii) a polymethacrylic ester, (iii) a polystyrene derivative, and (iv) a copolymer comprising two or more monomer units selected from the group of an acrylic ester, a methacrylic ester and a styrene derivative.

5. The radiation sensitive resin composition for forming a thick film resist pattern according to claim 4, wherein the photosensitizer containing a quinone diazide group is a mixture of two or more of esterified products having different esterification rate, which are produced by esterifying 1,2-naphthoquinone diazide sulfonic acid with tetrahydroxy benzophenone.

6. The radiation sensitive resin composition for forming a thick film resist pattern according to claim 4 or 5, which contains a fluorescent material in an amount of 0.0001 to 1.0 part by weight relative to 100 parts by weight of the photosensitizer containing a quinone diazide group.
